# EUROPEAN PATENT SPECIFICATION

(11) **EP 1 473 767 B1**
(45) Date of publication and mention of the grant of the patent: **09.05.2012**
(21) Application number: 04252117.9
(22) Date of filing: 08.04.2004
(51) Int. Cl.: H01L 21/285, H01L 23/522, H01L 23/532, H01L 21/768, G11C 13/02, H01L 27/24, B82Y 10/00

(54) **Method of forming conductive line for semiconductor device using carbon nanotube and semiconductor device manufactured using the method**
Verfahren zur Herstellung einer leitenden Bahn für eine Halbleitervorrichtung mit einer Kohlenstoffnanoröhre, und mit diesem Verfahren hergestellte Halbleitervorrichtung
Procédé pour la fabrication d'une ligne conductrice pour un dispositif semiconducteur avec un nanotube en carbone, et dispositif semiconducteur fabriqué par le procédé

(30) Priority: 01.05.2003 KR 2003028000
(43) Date of publication of application: 03.11.2004
(73) Proprietor: Samsung Electronics Co., Ltd., Suwon-si, Gyeonggi-do 442-742 (KR)
(72) Inventor: Choi, Won-bong, Yeongtong-gu Suwon-si Gyeonggi-do (KR); Bae, Eun-ju, Giheung-eub Yongin-si Gyeonggi-do (KR); Horii, Hideki, Gangnam-gu Seoul (KR)
(74) Representative: Greene, Simon Kenneth

(56) References cited:
- WO-A-01/61753
- DELZEIT LANCE ET AL: "Growth of multiwall carbon nanotubes in an inductively coupled plasma reactor" JOURNAL OF APPLIED PHYSICS, AMERICAN INSTITUTE OF PHYSICS. NEW YORK, US, vol. 91, no. 9, 1 May 2002 (2002-05-01), pages 6027-6033, XP012056377 ISSN: 0021-8979
- DELZEIT L ET AL: "Growth of carbon nanotubes by thermal and plasma chemical vapour deposition processes and applications in microscopy" NANOTECHNOLOGY, IOP, BRISTOL, GB, vol. 13, no. 3, June 2002 (2002-06), pages 280-284, XP002286793 ISSN: 0957-4484
- SOHN J I ET AL: "EFFECTS OF FE FILM THICKNESS AND PRETREATMENTS ON THE GROWTH BEHAVIOURS OF CARBON NANOTUBES ON FE-DOPED (001) SI SUBSTRATES" JAPANESE JOURNAL OF APPLIED PHYSICS, JAPAN SOCIETY OF APPLIED PHYSICS, TOKYO, JP, vol. 41, no. 7A, PART 1, July 2002 (2002-07), pages 4731-4736, XP001163075 ISSN: 0021-4922
- SUH JUNG SANG ET AL: "Highly ordered two-dimensional carbon nanotube arrays" APPLIED PHYSICS LETTERS, AIP, AMERICAN INSTITUTE OF PHYSICS, MELVILLE, NY, US, vol. 75, no. 14, 4 October 1999 (1999-10-04), pages 2047-2049, XP012023652 ISSN: 0003-6951

## Description

The present invention relates to a method of forming a conductive line for a semiconductor device, and more particularly, to a method of forming a conductive line for a semiconductor device using a carbon nanotube. The present invention also relates to a semiconductor device manufactured using the method.

There are many different semiconductor devices, in particular, semiconductor memory devices, for example, DRAM (Dynamic Random Access Memory, Dynamic RAM), SRAM (Static RAM), PRAM (Phase-change RAM), and MRAM (Magnetic RAM). In such semiconductor memory devices, an MOS (Metal Oxide Semiconductor) transistor is generally used as a switching device. In addition, semiconductor memory devices are provided with conductive lines, such as contacts and interconnects, as pathways for electron migration.

Recently, as semiconductor memory devices are highly integrated, the width of conductive lines decreases and the intensity of current per unit surface area, i.e., current density increases. In this regard, it is anticipated that the current density of conductive lines for semiconductor devices would reach 10⁶ A/cm² in the year 2010.

Meanwhile, metal conductive lines are mainly used in conventional semiconductor devices. It is known that the minimal width of metal conductive lines is 70 nm and the maximal current density of metal conductive lines is about 10⁶ A/cm². Decrease of the width and increase of current density of conductive lines are requisite for high integration of semiconductor devices. However, for the foregoing reasons, it is anticipated that semiconductor devices using metal conductive lines would undergo the limitation of integration in the near future.

Therefore, in order to continuously realize high integration of semiconductor devices, there is a need to develop new materials for conductive lines which can provide a high current density even at widths smaller than those of metal conductive lines.

WO 01/61753 describes a method of growing a carbon nanotube in a hole in an insulating layer. The carbon nanotube is grown on a seed layer formed using metal particles of nickel, iron, yttrium and/or cobalt.

Sohn J.I. et al.: "Effects of Fe film thickness and prereatments on the growth behaviours of carbon nanotubes on Fe-doped (001) Si substrates", Jpn.J.Appl.Phys. Vol.41 (2002) pp.4731-4736 discloses the growth of carbon nanotubes on laser-deposited Fe films on (001) silicon substrates. The Fe films are pre-treated at 800°C in NH3 or Ar, before carbon nanotubes are grown by CVD. Pre-treatment at 800°C causes agglomeration of Fe into clusters. Use of NH3 atmosphere during pre-treatment results in better-aligned carbon nanotubes and a faster growth rate.

Suh Jung Sang et al.: "Highly ordered two-dimensional carbon nanotube arrays", Applied Physics Letters, Vol.75, N.14, p.2047-2049 discloses growing carbon nanotubes with good vertical alignment on an anodised porous aluminum substrate. Co is used in the pores as a catalyst.

According to a first aspect of the present invention, there is provided a method of forming a conductive line for a semiconductor device according to claim 1.

According to specific embodiments of the present invention, in step (a), the surface of the electrode may be activated in a porous state by feeding, on the electrode surface, at least one pretreatment gas selected from the group consisting of nitrogen (N₂) gas, argon (Ar) gas, and ammonia (NH₃) gas, at a temperature range of 300 to 700°C.

In step (a), the surface of the electrode may be activated in a porous state by colliding an ionized Ar or N₂ gas with the electrode surface. In this case, step (a) may be performed at room temperature.

In step (b), the insulating layer may be made of oxide and the contact hole may be formed with the size of several nm to several tens nm in diameter.

Step (c) may be performed at a temperature range of 500 to 900°C by thermal chemical vapor deposition or plasma enhanced chemical vapor deposition.

In step (c), the carbon-containing gas may be at least one gas selected from the group consisting of CH₄, C₂H₂, C₂H₄, C₂H₆, CO, and CO₂. The carbon-containing gas may be fed together with at least one gas selected from the group consisting of H₂, N₂, and Ar.

The present invention provides a method of forming a conductive line for a semiconductor device, comprising growing a carbon nanotube on a surface of an electrode, which makes it possible to accomplish high integration of a semiconductor device.

The present invention also provides a semiconductor device capable of being highly integrated by having a conductive line comprised of a carbon nanotube formed by the above-described method.

The above and other features and advantages of the present invention will become more apparent by describing in detail exemplary embodiments thereof with reference to the attached drawings in which:
FIGS. 1A through 1D are sectional views showing sequential processes of forming a conductive line for a semiconductor device using a carbon nanotube according to the present invention;
FIG. 2A and 2B are schematic sectional views showing processes of forming a conductive line for a semiconductor device using a carbon nanotube according to a comparative example;
FIG. 3 is a photograph showing the structure of an active layer and a contact hole formed on an electrode after the process shown in FIG. 1C;
FIGS 4 and 5 are photographs showing carbon nanotubes grown on a surface of an electrode;
FIG. 6 is a photograph showing the uniformly arrayed structure of carbon nanotubes formed in a contact hole according to a conductive line formation method of the present invention; and
FIG. 7 is a schematic sectional view showing an example of semiconductor devices having conductive lines composed of carbon nanotubes according to a conductive line formation method of the present invention.

Hereinafter, preferred embodiments of the present invention will be described in detail with reference to accompanying drawings. The same reference numerals used in drawings indicates the same constitutional elements.

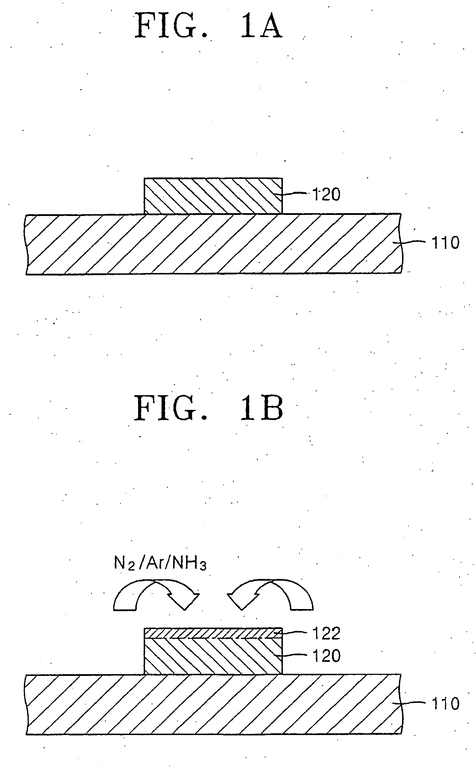

FIGS. 1A through 1D are sectional views showing sequential processes of forming a conductive line for a semiconductor device using a carbon nanotube according to the present invention.

FIG. 1A shows an electrode 120 formed on a substrate 110 for a semiconductor device. Referring to FIG. 1A, the substrate 110 may be silicon wafer, glass or the like. Meanwhile, the electrode 120 may be formed on a predetermined material layer, for example insulating layer, instead of the substrate 110. The electrode 120 may be made of metal with good conductivity or doped silicon. In detail, the electrode 120 may be made of doped silicon when formed on the silicon substrate 110 like a source electrode of MOSFET (Metal Oxide Semiconductor Field Effect Transistor). On the other hand, the electrode 120 may be made of metal with good conductivity when formed on an insulating layer.

FIG. 1B is a sectional view showing a process of activating a surface of the electrode 120 using surface pretreatment. Referring to FIG. 1B, when the substrate 110 and the electrode 120 reach a temperature range of about 300 to 700°C, a pretreatment gas is fed on the surface of the electrode 120 to thereby activate the surface of the electrode 120 in a porous state. As a result, an active layer 122, on which a carbon nanotube is to be grown, is formed on the surface of the electrode 120, as shown in FIG. 1B. Here, a nitrogen (N₂) gas, an argon (Ar) gas, or an ammonia (NH₃) gas may be used as the pretreatment gas. The duration and flow rate for feeding the pretreatment gas are controlled so that the thickness of the active layer 122 is in the range of about several nm to several tens nm.

Alternatively, the surface of the electrode 120 may be activated in a porous state by colliding an ionized Ar or N₂ gas with the surface of the electrode 120. This activation process can also form the porous active layer 122 which ensures growing of a carbon nanotube on the surface of the electrode 120. This activation process can be performed using a reactive ion etching (RIE) system. It is advantageous in that this activation process can be performed at room temperature without heating the substrate 110 and the electrode 120.

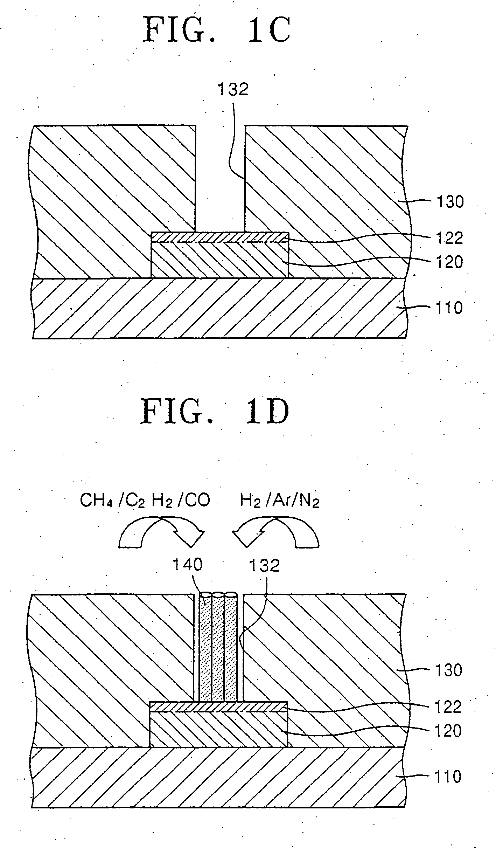

FIG. 1C is a sectional view showing the structure of an insulating layer 130 and a contact hole 132 formed on the electrode 120. Referring to FIG. 1C, first, the insulating layer 130 is formed on the electrode 120, the surface of which is formed with the active layer 122, as shown in FIG. 1B. Here, the insulating layer 130 may be made of oxide, for example silicon oxide (SiO₂).

Next, the contact hole 132 is formed in the insulating layer 130 in such a way that a part of the surface of the active layer 122 is exposed outside. In detail, a photoresist is applied over the insulating layer 130 and patterned in a predetermined shape. Then, the insulating layer 130 is anisotropic-etched using the patterned photoresist as an etching mask to form the contact hole 132. Here, the contact hole 132 may be formed with the size of several nm to several tens nm in diameter.

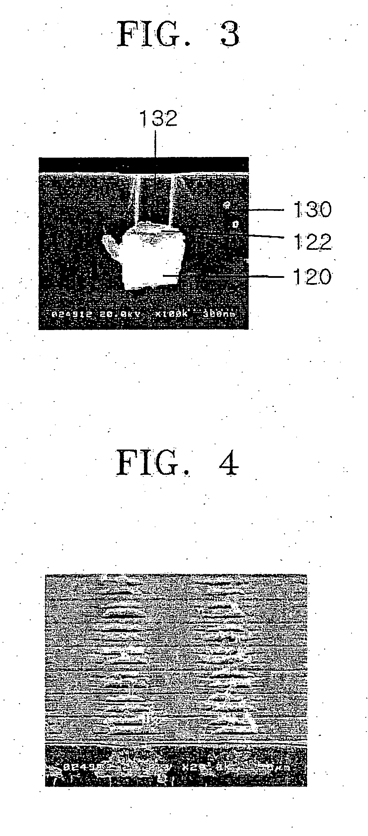

After the process shown in FIG. 1C, the active layer 122 is formed on the surface of the electrode 120 and the contact hole 132 is defined by the active layer 122 and the insulating layer 130, as shown in the photograph of FIG. 3.

FIG. 1D is a sectional view showing the structure of a carbon nanotube 140 grown on the active layer 122 in the contact hole 132. In FIG. 1D, the growing of the carbon nanotube 140 can be performed using thermal chemical vapor deposition or plasma enhanced chemical vapor deposition. The growing of the carbon nanotube 140 can also be performed using any other known methods.

Referring to FIG. 1D, the resultant formed by the above-described processes shown in FIGS. 1A through 1C is placed in a reaction furnace and then the reaction furnace is set to a temperature range of about 500 to 900°C. Then, a carbon-containing gas such as CH₄, C₂H₂, C₂H₄, C₂H₆, CO, and CO₂ is fed into the reaction furnace. Here, the carbon-containing gas is fed into the reaction furnace, together with H₂, N₂, or Ar gas. The carbon-containing gas fed into the reaction furnace is in contact with the active layer 122 formed on the surface of the electrode 120 via the contact hole 132. As a result, the carbon nanotube 140 is grown in a vertical direction from the active layer 122.

Next, although not shown in drawings, another type of an electrode or a memory thin film may be formed on the insulating layer 130 to be connected to the carbon nanotube 140. The carbon nanotube 140 forms a conductive line, such as contact or interconnect, for connecting the two electrodes (the electrode 120 and another type of electrode) or the electrode 120 and the memory thin film to each other.

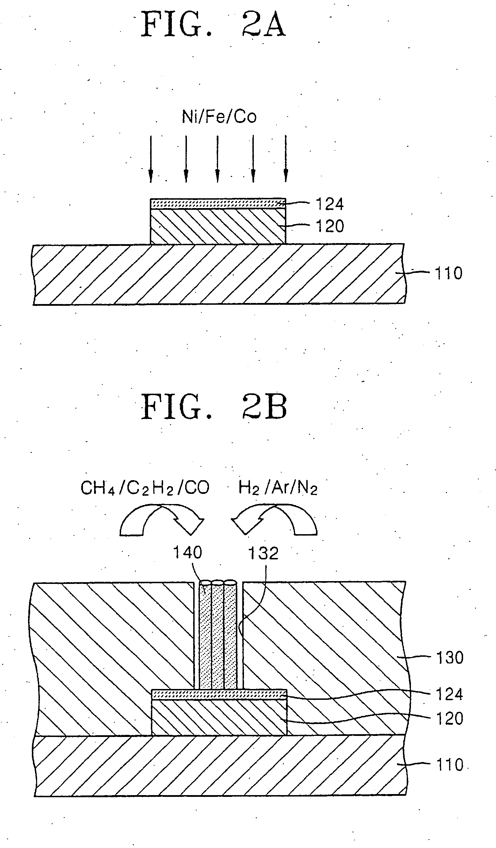

FIG. 2A and 2B are schematic sectional views showing processes of forming a conductive line for a semiconductor device using a carbon nanotube according to a comparative example. This example is the same as the invention except that a catalytic metal layer 124 is formed on the surface of the electrode.

FIG. 2A is a sectional view showing the structure of the catalytic metal layer 124 formed on the surface of the electrode 120. Referring to FIG. 2A, the catalytic metal layer 124, which ensures the growing of the carbon nanotube, is formed by depositing a catalytic metal in a predetermined thickness on the surface of the electrode 120 using a radio frequency (RF) magnetron sputter or an e-beam evaporator. Here, the catalytic metal may be a transition metal such as W, Ni, Fe, Co, Y, Pd, Pt, and Au. The catalytic metal layer 124 may be formed with a thickness of several nm to several tens nm.

Alternatively, the catalytic metal layer 124 may also be formed by applying a transition metal powder in a predetermined thickness on the surface of the electrode 120. Here, application of the transition metal powder may be performed in a thickness of several nm to several tens nm using spraying. An advantage of this process is that the catalytic metal layer 124 can be more easily formed in a coarse porous state.

In this way, according to the comparative example of FIG. 2, the catalytic metal layer 124 is separately formed on the surface of the electrode 120 to grow the carbon nanotube. Therefore, the example is different from the invention which directly activates the surface of the electrode 120 to grow the carbon nanotube. However, subsequent processes of the formation of the catalytic metal layer 124 on the surface of the electrode 120 in the example are the same as in the invention as described above.

As shown in FIG. 2B, the insulating layer 130 made of oxide (for example) is formed on the catalytic metal layer 124. Then, the insulating layer 130 is anisotropic-etched using a patterned photoresist as an etching mask to form the contact hole 132 with the size of several nm to several tens nm in diameter. As a result, a part of the surface of the catalytic metal layer 124 is exposed outside through the contact hole 132.

Next, while a carbon-containing gas, such as CH₄, C₂H₂, C₂H₄, C₂H₆, CO, and CO₂, and an H₂, N₂, or Ar gas, are fed into a reaction chamber of a temperature range of about 500 to 900°C, the carbon nanotube 140 is grown in a vertical direction from the surface of the catalytic metal layer 124.

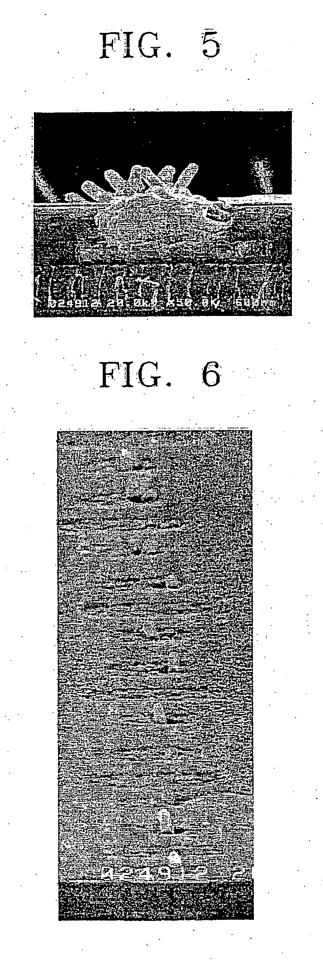

The photographs of FIGS 4 and 5 show carbon nanotubes grown on an activated surface of an electrode. The photograph of FIG. 6 shows the uniformly arrayed structure of carbon nanotubes formed in a contact hole according to a conductive line formation method of the present invention.

As described above, according to the conductive line formation methods of the present invention, the carbon nanotube can form a conductive line, such as contact and interconnect, for connecting the two electrodes (the electrode 120 and the another type of electrode) or the electrode 120 and the memory thin film to each other. Such a carbon nanotube has a current density of 10¹⁰ A/cm², which is about 10,000 times greater than that of a conventional metal conductive line. Therefore, a conductive line composed of the carbon nanotube can be formed with the size of several nm to several tens nm in diameter, and thus, can be used in fabrication of ultra-highly integrated semiconductor devices.

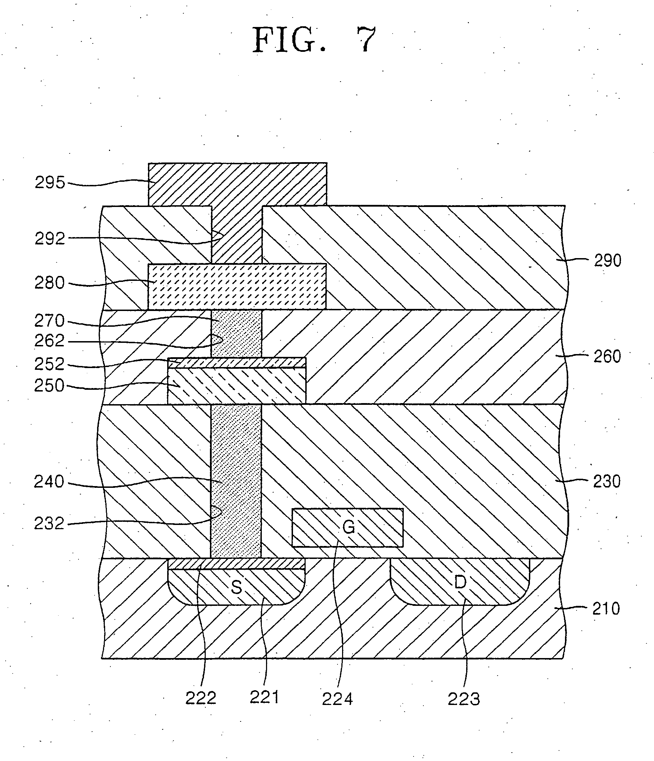

FIG. 7 is a schematic sectional view showing an example of semiconductor devices having conductive lines composed of carbon nanotubes according to a conductive line formation method of the present invention.

A semiconductor device exemplified in FIG. 7 is a phase-change random access memory (PRAM: Phase-change RAM) device having MOSFET as a switching device. A PRAM is a memory device using a phase-change material that experiences a change of electrical resistance according to its crystal state. The crystal state of a part of a phase-change material film is changed by variation in intensity of current applied to the phase-change material film.

Referring to FIG. 7, as well known, MOSFET consists of a source electrode 221 and a drain electrode 223 are formed in a predetermined region of a substrate 210, and a gate electrode 224 that is separated from the source electrode 221 and the drain electrode 223 by a first insulating layer 230. The source electrode 221 and the drain electrode 223 may be made of doped silicon or metal and the gate electrode 224 is mainly made of metal.

A first porous active layer 222 is formed on a surface of the source electrode 221 using the above-described conductive line formation method. Meanwhile, a catalytic metal layer may also be formed instead of the active layer 222. The first insulating layer 230 is formed on the first active layer 222. A first contact hole 232 is defined by the first insulating layer 230 and the first active layer 222. A first carbon nanotube 240 is grown in a vertical direction from the first active layer 222 in the first contact hole 232. Here, the first carbon nanotube 240 can have a diameter of several nm to several tens nm depending on the diameter of the first contact hole 232.

Next, an intermediate electrode 250 is formed on the first insulating layer 230 to be connected to the first carbon nanotube 240. Therefore, the first carbon nanotube 240 forms a conductive line that electrically connects the source electrode 221 and the intermediate electrode 250 to each other.

Similarly, a second porous active layer 252 or a catalytic metal layer is formed on a surface of the intermediate electrode 250 according to a conductive line formation method of the present invention. A second insulating layer 260 is formed on the second active layer 252. A second contact hole 262 is defined by the second insulating layer 260 and the second active layer 252. A second carbon nanotube 270 is grown in a vertical direction from the second active layer 252 in the second contact hole 262.

Next, a memory thin film 280 is formed on the second insulating layer 260 to be connected to the second carbon nanotube 270. The memory thin film 280 is made of a phase-change material. Therefore, the second carbon nanotube 270 forms a conductive line that electrically connects the intermediate electrode 250 and the memory thin film 280 to each other.

Alternatively, the memory thin film 280 may also be directly formed on the first carbon nanotube 240 grown on the source electrode 221 in the absence of the intermediate electrode 250 and the second carbon nanotube 270 formed thereon.

On the memory thin film 280, a third insulating layer 290 is formed. A third contact hole 292 is defined by the third insulating layer 290 and the memory thin film 280. The memory thin film 280 is connected to an upper electrode 295 that is formed on the third insulating layer 290 as well as in the third contact hole 292.

Up until now, application of a conductive line formation method of the present invention to a PRAM device was illustrated by way of an example. However, a conductive line formation method of the present invention can also be applied to various types of semiconductor memory devices, such as DRAM (Dynamic Random Access Memory, Dynamic RAM), SRAM (Static RAM), and MRAM (Magnetic RAM), in addition to PRAM. In such semiconductor memory devices, various types of transistors can be arranged as a switching device, in addition to MOSFET.

As apparent from the above descriptions, according to a method of forming a conductive line for a semiconductor device according to the present invention, a conductive line, such as contact and interconnect, which connects two electrodes or an electrode and a memory thin film to each other, can be formed using a carbon nanotube. Such a carbon nanotube has a current density of 10¹⁰ A/cm², which is about 10,000 times greater than that of a conventional metal conductive line. Therefore, a conductive line composed of the carbon nanotube can be formed with the size of several nm to several tens nm in diameter, and thus, can be used in fabrication of ultra-highly integrated semiconductor devices.

## Claims

1. A method of forming a conductive line for a semiconductor device, the method comprising:
(a) forming an active electrode surface of an electrode (120) of the semiconductor device;
(b) forming an insulating layer (130) on the surface of the electrode, and forming a contact hole (132) in the insulating layer in such a way that a part of the active surface of the electrode is exposed outside; and
(c) feeding a carbon-containing gas on the active surface of the electrode (120) via the contact hole (132) to grow a carbon nanotube (140), which forms the conductive line, on the activated surface of the electrode (120).
charactertised in that step (a), the active electrode surface of the electrode (120) is formed by activating a surface of the electrode (120) in a porous state using surface pretreatment

2. The method according to claim 1, wherein in step (a), the surface of the electrode is activated in a porous state by by feeding, on the electrode surface, at least one pretreatment gas selected from the group consisting of nitrogen (N₂) gas, argon (Ar) gas, and ammonia (NH₃) gas, at a temperature range of 300 to 700°C.

3. The method according to claim 1, wherein in step (a) the surface of the electrode (120) is activated ina porous state by colliding an ionized Ar or N2 gas with the electrode surface.

4. The method according to claim 3 wherein step (a) is performed at room temperature.

5. The method according to any preceding claim, wherein in step (a), the activated surface of the electrode is formed with a thickness of several nm to several tens nm.

6. The method according to any preceding claim, wherein in step (b), the insulating layer is made of oxide.

7. The method according to any preceding claim, wherein in step (b), the insulating layer is anisotropic-etched using a patterned photoresist as an etching mask to form the contact hole.

8. The method according to any preceding claim, wherein in step (b), the contact hole is formed with the size of several nm to several tens nm in diameter.

9. The method according to any preceding claim, wherein step (c) is performed at a temperature range of 500 to 900°C.

10. The method according to any preceding claim, wherein in step (c), the carbon-containing gas is at least one gas selected from the group consisting of CH₄, C₂H₂, C₂H₄, C₂H₆, CO, and CO₂.

11. The method according to any preceding claim, wherein in step (c), the carbon-containing gas is fed together with at least one gas selected from the group consisting of H₂, N₂, and Ar.

12. The method according to any preceding claim, wherein step (c) is performed by thermal chemical vapor deposition or plasma enhanced chemical vapor deposition.

13. A semiconductor device comprising:
a substrate;
an electrode formed on the substrate;
a porous active layer formed on a surface of the electrode;
an insulating layer, which is formed on the active layer and has a contact hole to expose a part of the active layer;
a carbon nanotube, which is grown on the active layer in the contact hole and forms a conductive line as a pathway for electron migration; and
a memory thin film, which is formed on the insulating layer and is electrically connected to the carbon nanotube.

14. The semiconductor device according to claim 13, wherein the substrate is made of silicon or oxide.

15. The semiconductor device according to any of claims 13 to 14, wherein the electrode is a source electrode of MOSFET (Metal Oxide Semiconductor Field Effect Transistor).

16. The semiconductor device according to any of claims 13 to 15, wherein the memory thin film is made of a phase-change material.

## Patentansprüche

1. Verfahren zur Herstellung einer leitenden Bahn für eine Halbleitervorrichtung, wobei das Verfahren umfasst:
(a) Ausbilden einer aktiven Elektrodenoberfläche einer Elektrode (120) der Halbleitervorrichtung,
(b) Ausbilden einer Isolierschicht (130) auf der Oberfläche der Elektrode und Ausbilden eines Kontaktlochs (132) in der Isolierschicht derart, dass ein Teil der aktiven Oberfläche der Elektrode zur Außenseite freigelegt ist, und
(c) Zuführen eines Kohlenstoff enthaltenden Gases auf die aktive Oberfläche der Elektrode (120) über das Kontaktloch (132), so dass auf der aktivierten Oberfläche der Elektrode (120) ein Kohlenstoff-Nanoröhrchen (140) aufwächst, das die leitende Bahn bildet,
**dadurch gekennzeichnet, dass** in Schritt (a) die aktive Elektrodenoberfläche der Elektrode (120) durch Aktivieren einer Oberfläche der Elektrode (120) in einen porösen Zustand unter Anwendung einer Oberflächenvorbehandlung gebildet wird.

2. Verfahren nach Anspruch 1, wobei in Schritt (a) die Oberfläche der Elektrode durch Zuführen mindestens eines Vorbehandlungsgases, das ausgewählt ist aus der Gruppe bestehend aus Stickstoffgas (N₂), Argongas (Ar) und Ammoniakgas (NH₃), zur Elektrodenoberfläche in einem Temperaturbereich von 300 bis 700 °C in einen porösen Zustand aktiviert wird.

3. Verfahren nach Anspruch 1, wobei in Schritt (a) die Oberfläche der Elektrode (120) durch Kollision eines ionisierten Argon- oder N₂-Gases mit der Elektrodenoberfläche in einen porösen Zustand aktiviert wird.

4. Verfahren nach Anspruch 3, wobei Schritt (a) bei Raumtemperatur durchgeführt wird.

5. Verfahren nach einem der vorhergehenden Ansprüche, wobei in Schritt (a) die aktivierte Oberfläche der Elektrode mit einer Dicke von einigen Nanometern (nm) bis zu einigen Dutzend Nanometern ausgebildet wird.

6. Verfahren nach einem der vorhergehenden Ansprüche, wobei in Schritt (b) die Isolierschicht aus Oxid gebildet wird.

7. Verfahren nach einem der vorhergehenden Ansprüche, wobei in Schritt (b) die Isolierschicht anisotrop geätzt wird, wobei ein gemusterter Photoresist als Ätzmaske verwendet wird, um das Kontaktloch auszubilden.

8. Verfahren nach einem der vorhergehenden Ansprüche, wobei in Schritt (b) das Kontaktloch mit einer Größe von einigen Nanometern (nm) bis zu einigen Dutzend Nanometern im Durchmesser ausgebildet wird.

9. Verfahren nach einem der vorhergehenden Ansprüche, wobei Schritt (c) in einem Temperaturbereich von 500 bis 900 °C durchgeführt wird.

10. Verfahren nach einem der vorhergehenden Ansprüche, wobei in Schritt (c) das Kohlenstoff enthaltende Gas mindestens eines ausgewählt aus der Gruppe bestehend aus CH₄, C₂H₂, C₂H₄, C₂H₆, CO und CO₂ ist.

11. Verfahren nach einem der vorhergehenden Ansprüche, wobei in Schritt (c) das Kohlenstoff enthaltende Gas zusammen mit mindestens einem Gas ausgewählt aus der Gruppe bestehend aus H₂, N₂ und Ar zugeführt wird.

12. Verfahren nach einem der vorhergehenden Ansprüche, wobei Schritt (c) durch thermisch chemisches Aufdampfen (TCVD) oder plasmaunterstütztes chemisches Aufdampfen (PECVD) durchgeführt wird.

13. Halbleitervorrichtung, umfassend:
ein Substrat,
eine auf dem Substrat ausgebildete Elektrode,
eine auf einer Oberfläche der Elektrode ausgebildete poröse aktive Schicht,
eine Isolierschicht, die auf der aktiven Schicht ausgebildet ist und ein Kontaktloch aufweist, um einen Teil der aktiven Schicht freizulegen,
ein Kohlenstoff-Nanoröhrchen, das auf der aktiven Schicht im Kontaktloch aufgewachsen ist und eine leitende Bahn als Weg für eine Elektronenmigration bildet, und
einen Speicherdünnfilm, der auf der Isolierschicht ausgebildet ist und mit dem Kohlenstoff-Nanoröhrchen elektrisch verbunden ist.

14. Halbleitervorrichtung nach Anspruch 13, wobei das Substrat aus Silicium oder Oxid gebildet ist.

15. Halbleitervorrichtung nach einem der Ansprüche 13 oder 14, wobei die Elektrode eine Source-Elektrode eines MOSFET (Metal Oxide Semiconductor Field Effect Transistor) ist.

16. Halbleitervorrichtung nach einem der Ansprüche 13 bis 15, wobei der Speicherdünnfilm aus einem Phasenwechselmaterial (Phase-Change-Material) gebildet ist.

## Revendications

1. Procédé de formation d'une ligne conductrice pour un dispositif semiconducteur, le procédé consistant à :
(a) former une surface d'électrode active d'une électrode (120) du dispositif semiconducteur ;
(b) former une couche isolante (130) sur la surface de l'électrode, et former un orifice de contact (132) dans la couche isolante de telle manière qu'une partie de la surface active de l'électrode soit exposée à l'extérieur ; et
(c) envoyer un gaz contenant du carbone sur la surface active de l'électrode (120) via l'orifice de contact (132) pour développer un nanotube de carbone (140), qui forme la ligne conductrice, sur la surface activée de l'électrode (120),
**caractérisé en ce que** dans l'étape (a), la surface d'électrode active de l'électrode (120) est formée en activant une surface de l'électrode (120) dans un état poreux au moyen d'un pré-traitement de surface.

2. Procédé selon la revendication 1, dans lequel dans l'étape (a), la surface de l'électrode est activée dans un état poreux en fournissant, sur la surface d'électrode, au moins un gaz de pré-traitement choisi dans le groupe constitué par l'azote gazeux (N₂), le gaz argon (Ar) et le gaz ammoniac, à une plage de températures de 300 à 700°C.

3. Procédé selon la revendication 1, dans lequel dans l'étape (a), la surface de l'électrode (120) est activée dans un état poreux par collision d'un gaz Ar ou N2 ionisé avec la surface d'électrode.

4. Procédé selon la revendication 3, dans lequel l'étape (a) est réalisée à température ambiante.

5. Procédé selon l'une quelconque des revendications précédentes, dans lequel dans l'étape (a), la surface activée de l'électrode est formée avec une épaisseur de plusieurs nm à plusieurs dizaines de nm.

6. Procédé selon l'une quelconque des revendications précédentes, dans lequel dans l'étape (b), la couche isolante est composée d'oxyde.

7. Procédé selon l'une quelconque des revendications précédentes, dans lequel dans l'étape (b), la couche isolante fait l'objet d'une gravure anisotrope au moyen d'une photorésine à motifs en tant que masque de gravure pour former l'orifice de contact.

8. Procédé selon l'une quelconque des revendications précédentes, dans lequel dans l'étape (b), l'orifice de contact est formé à la taille de plusieurs nm à plusieurs dizaines de nm de diamètre.

9. Procédé selon l'une quelconque des revendications précédentes, dans lequel l'étape (c) est réalisée à une plage de températures de 500 à 900°C.

10. Procédé selon l'une quelconque des revendications précédentes, dans lequel dans l'étape (c), le gaz contenant du carbone est au moins un gaz choisi dans le groupe constitué par CH₄, C₂H₂, C₂H₄, C₂H₆, CO et CO₂.

11. Procédé selon l'une quelconque des revendications précédentes, dans lequel dans l'étape (c), le gaz contenant du carbone est fourni conjointement avec au moins un gaz choisi dans le groupe constitué de H₂, N₂, et Ar.

12. Procédé selon l'une quelconque des revendications précédentes, dans lequel l'étape (c) est réalisée par dépôt thermochimique en phase vapeur ou dépôt chimique en phase vapeur activé par plasma.

13. Dispositif semiconducteur comprenant :
un substrat ;
une électrode formée sur le substrat ;
une couche active poreuse formée sur une surface de l'électrode ;
une couche isolante, qui est formée sur la couche active et possède un orifice de contact pour exposer une partie de la couche active ;
un nanotube de carbone, qui est développé sur la couche active dans l'orifice de contact et forme une ligne conductrice qui sert de voie de cheminement pour la migration des électrons ; et
un film mince à mémoire, qui est formé sur la couche isolante et est connecté électriquement au nanotube de carbone.

14. Dispositif semiconducteur selon la revendication 13, dans lequel le substrat est constitué de silicium ou d'oxyde.

15. Dispositif semiconducteur selon l'une quelconque des revendications 13 à 14, dans lequel l'électrode est une électrode source de MOSFET (transistor à effet de champ métal-oxyde semiconducteur).

16. Dispositif semiconducteur selon l'une quelconque des revendications 13 à 15, dans lequel le film mince à mémoire est constitué d'un matériau à changement de phase.
